Europäisches Patentamt

European Patent Office

Office européen des brevets

(19)

(11) **EP 1 382 104 B1**

(12) **EUROPÄISCHE PATENTSCHRIFT**

(45) Veröffentlichungstag und Bekanntmachung des Hinweises auf die Patenterteilung:
**17.08.2005 Patentblatt 2005/33**

(51) Int Cl.7: **H02H 6/00**, H02H 7/085, G01R 31/34

(21) Anmeldenummer: 02732634.7

(86) Internationale Anmeldenummer:
**PCT/EP2002/004263**

(22) Anmeldetag: **17.04.2002**

(87) Internationale Veröffentlichungsnummer:
**WO 2002/087050 (31.10.2002 Gazette 2002/44)**

(54) **VERFAHREN UND VORRICHTUNG ZUM MESSEN DER WICKLUNGSTEMPERATUR EINES ANTRIEBSMOTORS**

METHOD AND DEVICE FOR MEASURING THE TEMPERATURE OF WINDINGS OF A DRIVE MOTOR

PROCEDE ET DISPOSITIF POUR MESURER LA TEMPERATURE D'ENROULEMENTS D'UN MOTEUR D'ENTRAINEMENT

(84) Benannte Vertragsstaaten:
**AT BE CH CY DE DK ES FI FR GB GR IE IT LI LU MC NL PT SE TR**

(30) Priorität: **19.04.2001 DE 10119201**

(43) Veröffentlichungstag der Anmeldung:
**21.01.2004 Patentblatt 2004/04**

(73) Patentinhaber: **BSH Bosch und Siemens Hausgeräte GmbH**
**81739 München (DE)**

(72) Erfinder: **KLEIN, Hans-Wilhelm**
**97078 Würzburg (DE)**

(56) Entgegenhaltungen:
EP-A- 0 247 996          DE-C- 19 743 046
US-A- 4 670 698          US-A- 4 829 234

• **PATENT ABSTRACTS OF JAPAN vol. 18, no. 137 (E-1518), 7. März 1994 (1994-03-07) -& JP 05 316638 A (FUJI ELECTRIC CO LTD), 26. November 1993 (1993-11-26)**
• **PATENT ABSTRACTS OF JAPAN vol. 11, no. 226 (P-598), 23. Juli 1987 (1987-07-23) -& JP 62 042074 A (MEIDENSHA ELECTRIC MFG CO LTD), 24. Februar 1987 (1987-02-24)**

**Beschreibung**

Die vorliegende Erfindung betrifft ein Verfahren zum Messen der Wicklungstemperatur eines Antriebsmotors und eine dementsprechende Vorrichtung.

Eine einschlägige Vorrichtung nach dem Oberbegriff von Anspruch 9 sowie ein entsprechendes Verfahren sind aus der DE-A-197 43 046 bekannt.

Bisher wurden zur Messung der Wicklungstemperatur Thermowächter bzw. Thermoprotektoren in Form von kombinierten Temperatursensoren und Schaltern eingesetzt, die in enger thermischer Koppelung zu den Wicklungen angeordnet sind. Bei Erreichen von bestimmten Ansprechtemperaturen wird hiermit die Motorwicklung abgeschaltet. Dieses Verfahren erfordert mindestens ein zusätzliches Bauelement der eingangs erwähnten Bauart.

Weiterhin ist ein Verfahren bekannt, bei dem aus der Messung des Wicklungsstromes und einer Zeitdauer ein Ersatzwert für die Wicklungstemperatur ermittelt wird. Als Ersatzwert wird hier z.B. das Produkt aus dem Quadrat des Wicklungsstromes und der Einschaltdauer $t_e$ entsprechend der Gleichung $P = I^2 * t_e$ verwendet. Nachteilig ist hier die Ungenauigkeit des Verfahrens, da Toleranzen und andere Einflüsse nur sehr eingeschränkt berücksichtigt werden können. Nach diesem Verfahren arbeiten u.a. sogenannte Motorschutzschalter, bei denen über durch den Stromfluß beheizte Bimetalschalter die Stromwärme genutzt wird, um indirekt auf die Wicklungstemperatur zurückzuschließen.

Ein bezüglich der Stromerfassung anderes Verfahren macht spezielle Sensoren erforderlich, um eine ausreichend genaue Stromabbildung zu ermöglichen. Bekannt sind hier u.a. auf der Basis von Hall-Elementen arbeitende Stromsensoren in einem Magnetringkern, der den Leiter umschließt, in dem der Strom gemessen werden soll. Der Stromsensor befindet sich in einer Anschlußleitung zur Motorwicklung. Der erfaßte Stromwert liegt gegenüber dem Strom selbst als potentialfreies Signal vor. Nach diesem Verfahren gemessene Ströme können zur Ermittlung des Wicklungswiderstandes verwendet werden. Hierzu ist außer dem Strom die Zwischenkreisspannung zu messen und entsprechend $R = U / I$ der Wicklungswiderstand bzw. Teile oder ein Mehrfaches davon unter Berücksichtigung der Spannungsfälle an der Steuerelektronik zu ermitteln. Aus der Änderung der ermittelten R- Werte kann auf die Wicklungstemperatur geschlossen werden. Dieses Verfahren bietet sich bei Motoransteuerelektroniken an, bei dem ein entsprechend kurzzeitiges Einschalten der Wicklung oder Wicklungen möglich ist, wie Umrichter mit Pulsbreitenmodulation. Die Stromerfassung selbst ist durch die Sensorik relativ aufwendig gestaltet.

Es ist daher Aufgabe der vorliegenden Erfindung, ein Verfahren, eine dementsprechende Vorrichtung und ein Steuerungssystem zu schaffen, die genauere Ergebnisse bei geringem schaltungstechnischen Aufwand liefern.

Diese Aufgabe wird erfindungsgemäß durch ein Verfahren mit den Merkmalen von Anspruch 1 und durch eine Vorrichtung mit den Merkmalen von Anspruch 9 gelöst. Ferner ist auch ein Hausgerät mit den Merkmalen von Anspruch 14 eine Lösung der vorstehenden Aufgabe. Vorteilhafte Weiterbildungen der Erfindung sind Gegenstand der jeweiligen Unteransprüche.

Ein erfindungsgemäßes Verfahren zur Messung der Wicklungstemperatur sieht vor, dass auf bekannte Schaltungen aufgebaut wird. Aus der deutschen Offenlegungsschrift DE-OS 2 333 978 ist zur Drehzahlregelung von Induktionsmotoren eine über Halbleiterelemente steuerbare Brückenschaltung bekannt, die aus einem Gleichspannungs-Zwischenkreis einen dreiphasigen Wechselstrom zur Speisung eines dreiphasigen, dreisträngigen Motors aufbereitet. Dieses Prinzip und die Verwendung entsprechender Schaltungen hat sich bewährt. So wird auch in der Anmeldung EP 0 866 339 A1 prinzipiell auf dieser Schaltung aufbauend ein Verfahren und eine Schaltungsanordnung vorgestellt, bei dem aus Strommessungen in den Querzweigen eines mehrsträngigen Wechselrichters durch eine spezielle Auswertung die Motorströme ermittelt werden, um diese als Istwerte einer Regelung der Motordrehzahl zuzuführen.

Der Erfindung liegt weiter die Erkenntnis zugrunde, dass eine kurzzeitig andauernde Belastung nicht zu einer Überhitzung eines Motors führen kann, da jeder Motor eine hohe thermische Kapazität aufweist. Erfindungsgemäß wird eine Temperaturüberwachung über eine Messung der Wicklungswiderstände des geregelten Motors vorgenommen, indem ein Vergleich zwischen einem Wert eines jeweiligen Kaltwiderstands und einem aktuellen Widerstand im erwärmten Zustand durchgeführt wird.

In einer wesentlichen Weiterbildung der Erfindung erfolgen Messungen im Zuge einer Langzeitüberwachung nicht kontinuierlich. Als effektiver Schutz vor Überhitzung des Motors ist damit eine Langzeitüberwachung ausreichend, die auch nicht kontinuierlich vorgenommen werden muß, sondern zu diskreten Zeitpunkten erfolgen kann. Diese Meßmethode ist in besonderer Weise auch an tatsächliche Betriebsbedingungen moderner Motoren angepaßt. Insbesondere in Hausgeräten, wie z.B. Waschmaschinen, Schleudern, etc. als Wäschebehandlungsvorrichtungen mit größeren Motorleistungen, laufen Motoren nicht kontinuierlich mit gleicher Drehzahl und in gleicher Richtung. Es findet zur Erzeugung einer bestimmten Waschmechanik oder einer besseren Verteilung des Waschguts innerhalb einer Wäschetrommel und zur Minderung einer Unwucht vielmehr ein Wechsel zwischen den Drehrichtungen statt. Im Zuge der wechselnden Drehrichtungen treten immer wieder kurze Pausen oder Stillstandsphasen auf, in denen der Motor auch stromlos geschaltet ist. Vorzugsweise werden gerade diese Pausen zur Messung eines aktuellen Wertes der Wicklungswiderstände genutzt.

Prinzipiell kann bei genauer Kenntnis des Kaltwiderstandes und der sonstigen Materialparameter aus einer Widerstandsmessung durch den Umrichter hindurch auf die Temperatur der Motorwicklungen rückgeschlossen werden. Damit wird eine schon vorhandene Schaltung unter Eingriff durch ein ebenfalls schon vorhandenes Steuerungsmittel lediglich über kurze Zeitabschnitte einer zusätzlichen Aufgabe zugeführt. Auf der Grundlage einer Strom- und Spannungsmessung kann dieses Verfahren wahlweise auch während des laufenden Motors durchgeführt werden.

In einer Ausführungsform der Erfindung wird aus dem stromlosen Zustand heraus die Zeit bis zum Erreichen eines Strom-Schwellwertes bei Anlegen einer Meßspannung, vorzugsweise der Zwischenkreisspannung, gemessen. Diese Meßzeit bis zum Ansprechen eines Schwellwertschalters oder Komparators verkürzt sich durch eine durch die Erwärmung der Wicklung bewirkte Erhöhung des Gesamtwiderstandes deutlich meßbar.

In einer alternativen Ausführungsform der Erfindung werden bei ansteigendem Stromfluß zu zwei Zeitpunkten Messungen der Stromwerte durch den Motor hindurch gemessen.

Dabei sind die zwei Zeitpunkte der Messung in ihrem Abstand zueinander fest vorgegeben. So läßt sich bei prinzipiell bekanntem Kurvenverlauf wiederum eine Widerstandsänderung und mithin eine Temperaturerhöhung berechnen.

Vorteilhafterweise werden die Meßwerte gespeichert, so dass aufeinander folgende Werte miteinander verglichen werden können, um eine Veränderung der Wicklungstemperatur feststellen zu können. So wird auch ein allmähliges Annähern einer aktuellen Wicktungstemperatur an einen kritischen Temperaturbereich ausreichend frühzeitig bemerkt, so dass von der Motorsteuerung aus durch geeignete Maßnahmen für eine Abkühlung gesorgt werden, mindestens aber einem weiteren Ansteigen der aktuellen Wicklungstemperatur entgegengewirkt werden kann. Ein einfaches Mittel kann bereits in einer Reduzierung der Einschaltdauer des Motors gegeben sein. Zudem sollte eine Meldung an einen Anwender ausgegeben werden, damit durch eine Kontrolle der Zufuhrwege für Frischluft thermische Probleme und eine damit erfindungsgemäß zum Schutz des Motors automatisch veranlaßte Verlängerung einer Programmlaufzeit beseitigt werden können. Erfahrungsgemäß sind Staubansammlungen, verstopfte oder schlecht gewartete Filter, oder auch ein versehentlich die Zufuhrwege für Frischluft abdeckender Gegenstand leicht und schnell beseitigbare Ursachen für stark erhöhte Motortemperaturen, die ohne Verwendung eines erfindungsgemäßen Schutzmechanismus in kurzer Zeit zu einem thermisch verursachten Ausfall des Motors führen würden.

Ein Kaltwiderstand der Motorwicklungen und sonstige Motorparameter können bei der Installation einmalig gemessen und in einer Vorrichtung zur Temperatur-Überwachung fest gespeichert werden. Bei größeren Serienfertigungen sind Abweichungen von bis ca. 5% jedoch akzeptabel, so dass hier auch aus Kostengründen mit fest vorgegebenen Standardwerten gearbeitet werden kann. Auf weitere Näherungen wird nachfolgend in Zusammenhang mit der Beschreibung eines Ausführungsbeispiels eingegangen.

Als Ergänzung zu der reinen Temperaturüberwachung kann auch der durch den Umrichter zufließende Strom überwacht werden. Dazu sind zwei Meßschwellen, eine Vorwarnschwelle und eine darüberliegende Notabschaltschwelle, in einer Stromauswerteschaltung definiert. Dabei kann die Stromauswerteschaltung beispielsweise durch Rückgriff auf einen Spannungsabfall in dem allen Halbbrücken des Umrichters gemeinsamen Shunt in jedem Betriebszustand erfolgen, also ohne Beeinträchtigung auch während des laufenden Motors.

Vorteilhafterweise werden durch ein erfindungsgemäßes Verfahren und eine dementsprechende Vorrichtung neue Möglichkeiten zur einfachen und sicheren Temperaturüberwachung bei Elektromotoren beliebiger Bauform und Antriebsgestaltung geschaffen. Es ist dabei erfindungsgemäß kein Sensor und keine zusätzliche analoge Stromerfassung erforderlich. Zudem sind keinerlei Änderungen oder Eingriffe an dem Elektromotor selber vorzunehmen, da ein erfindungsgemäßes Verfahren eine indirekte Messung vorsieht und vollständig im Bereich eines Leistungsumrichters umgesetzt wird. Es sind mithin auch keine zusätzlichen Leitungen zwischen dem Elektromotor und dem Leistungsumrichter vorzusehen.

Nachfolgend wird ein Ausführungsbeispiel der Erfindung anhand der Zeichnung näher erläutert. In der Zeichnung zeigt:

Figur 1:    eine skizzierte Darstellung eines erfindungsgemäßen Systems und

Figur 2:    ein Diagramm zur Darstellung des prinzipiellen zeitlichen Verlaufes des temperaturabhängigen Widerstands einer Motorwicklung.

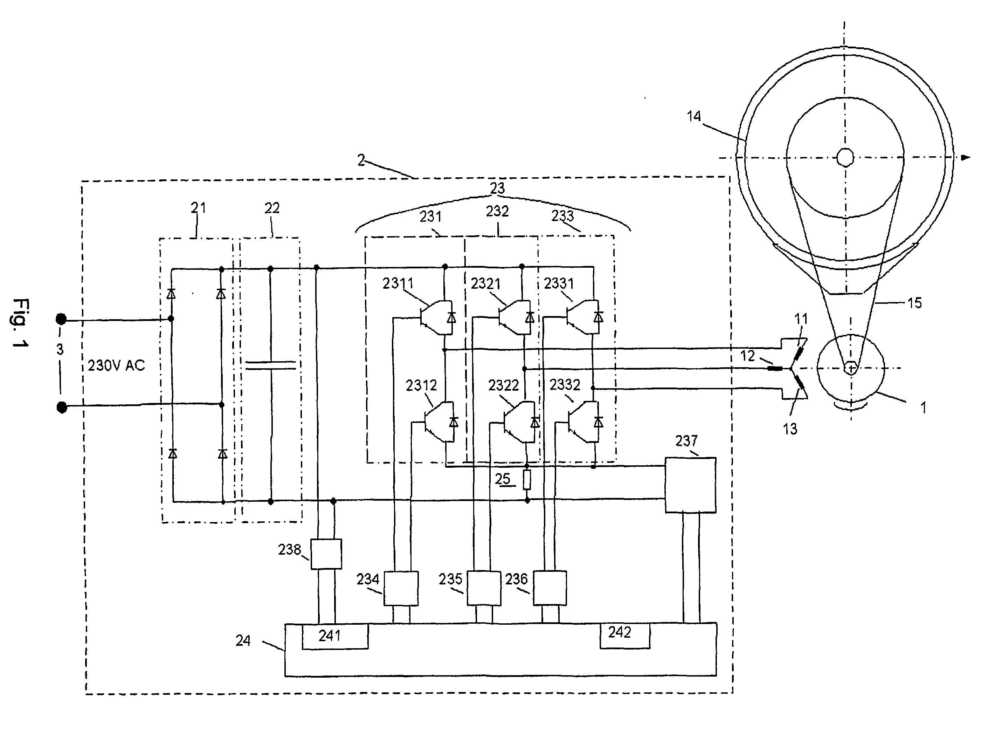

Die Abbildung von Figur 1 zeigt eine Vorrichtung zur Umsetzung eines erfindungsgemäßen Verfahrens unter Verwendung eines Asynchronmotors 1, der über einen Umrichter 2 mit einer Netzspannung 3 verbunden ist. Außer der Steuerung im normalen Motorbetrieb werden mit der nachfolgend beschriebenen Schaltungsanordnung Wicklungswiderstände erfaßt, über deren Änderung auf der Grundlage einer nachfolgend hergeleiteten Formel eine aktuelle Wicklungstemperatur bestimmt wird. Dabei baut ein erfindungsgemäßes Verfahren auf einer aus dem Stand der Technik bekannten Schaltungsanordnung auf. Sie stellt eine vorteilhafte Erweiterung zur Überwachung der Wicklungstemperatur des Motors 1 dar, die bei geringen Mehrkosten sofort in diversen Antrieben eingesetzt werden kann, also nicht nur bei Asynchronmotoren mit Riemengetriebe, sondern auch Synchronmotoren in Direktantrieben etc.

Der Umrichter 2 umfaßt u.a. einen Gleichrichter 21, der aus dem Wechselspannungsnetz 3 einen Gleichspannungszwischenkreis 22 versorgt. An diesem Zwischenkreis 22 wird ein 3-phasiger Wechselrichter 23 betrieben, der im wesentlichen aus drei Halbbrücken 231, 232, 233 besteht, die wiederum je zwei Schalter in Form von Leistungshalbleitern 2311, 2312, 2321, 2322, 2331, 2332 und dazugehörige Treiber 234, 235, 236 aufweist. Über die Halbbrücken 231, 232, 233 wird die Spannung des Zwischenkreises mittels Pulsweitenmodulation, im weiteren abgekürzt als PWM bezeichnet, an drei im Stern geschalteten Wicklungen 11, 12, 13 des Asynchronmotors 1 geschaltet. Mit einer sinusbewerteten PWM werden sinusförmige Motorströme erzeugt. Hierbei werden die erforderlichen Pulsmuster von einem Mikrocontroller 24 erzeugt und über die Treiber 234, 235, 236 den Leistungsschaltern 2311, 2312, 2321, 2322, 2331, 2332 vorgegeben.

Weiterhin sind eine Stromerfassungsschaltung 25 und eine Stromauswerteschaltung 237 vorgesehen. Ebenfalls ist eine Erfassungsschaltung für die Zwischenkreisspannung 238 notwendig. Beide Erfassungsschaltungen sind mit dem Mikrocontroller 24 verbunden, der die Berechnung des Wicklungswiderstandes, dessen Änderung und daraus die Bestimmung der Wicklungstemperatur vornimmt. Die Stromerfassungsschaltung 25 ist in der vorliegenden Ausführungsform in Form eines Shunts 25 in die Verbindungsleitung zwischen dem Minuspol des Zwischenkreises 22 und dem Wechselrichter 23 geschaltet und erfaßt damit den gesamten Strom des Motors 1. Die Stromauswerteschaltung 237 besteht im wesentlichen aus einer Komparatorschaltung, die einen Stromwert mit einem Referenzwert vergleicht. Bei Erreichen eines Referenzwertes findet ein Zustandswechsel eines Binärsignales zur Beendigung einer Zeitmessung statt, deren Ergebnis von dem Mikrocontroller 24 nach einer im folgenden noch im Detail hergeleiteten Formel ausgewertet wird.

Die Zwischenkreisspannung wird als analoger Wert in der Erfassungsschaltung 238 mittels eines Spannungsteilers erfaßt und über einen analog/digital-Wandler bzw. A/D-Wandler 241 in den Mikrocontroller 24 eingelesen. Dabei kann der A/D-Wandler 241 in bekannter Weise als integraler Teil des Mikrocontrollers 24 ausgeführt, wie auch die Stromauswerteschaltung 237 und sonstige Komponenten der beschriebenen Vorrichtung. Die einzelnen Einrichtungen können jedoch auch diskret aufgebaut werden, so dass ein bereits vorhandener Mikrocontroller 24 nicht verändert bzw. erweitert werden muß.

Voraussetzung für die Erfassung des Wicklungswiderstandes ist, dass die Wicklungszeitkonstante $\tau$ bekannt ist. Für den Einsatz dieser Schaltung mit einer bestimmten Motortype besteht hierin aber keine zusätzliche Forderung, zumal derartige Kenngrößen und Motorparameter für eine Drehzahlregelung ohnehin bekannt sein müssen. Dabei werden diese Parameter in dem Mikrocontroller 24 bzw. in dem dazugehörigen Speicherbaustein 242 abgespeichert. Fertigungstoleranzen können in dem hier beschriebenen Fall einer Auslegung für eine Serien- bzw. Massenfertigung vernachlässigt werden. Aufgrund der nachfolgend dargestellten relativen Auswertung der Wicklungswiderstände, d.h. einer Erfassung nur von Änderungen der jeweiligen Werte, ist es unerheblich, ob nun ein Wicklungswiderstand oder, wie hier beschrieben, zwei in Reihe geschaltete Wicklungswiderstände ausgewertet werden. Für die Messung ist die Durchschaltung von mindestens zwei Halbleiterschaltern erforderlich, deren Spannungsfälle gegenüber der Zwischenkreisspannung ebenfalls vernachlässigt werden, da diese nur maximal etwa 2% der Zwischenkreisspannung betragen und deren Änderungen über der Temperatur nur Bruchteile dieser Werte betragen. Weiterhin kann der Shuntwiderstand 25 gegenüber den Wicklungswiderständen vernachlässigt werden. Darüber hinaus wird vorausgesetzt, dass bis zum Erreichen eines Stromreferenzwertes magnetische Sättigungseinflüsse ebenfalls vernachlässigbar sind.

Der Ablauf der Messung geschieht in einer ersten Ausführungsform folgendermaßen:

Im Stillstand des Motors 1 wird durch ein mit dem Mikrocontroller 24 vorgegebenes Pulsmuster jeweils ein Schalttransistor in zwei unterschiedlichen Halbbrücken eingeschaltet, z.B. 2311 und 2322 in den Halbbrücken 231 und 232, so dass ein Strom i entsprechend der angenommenen Sternschaltung der Asynchronmotorwicklung des Motors 1 über die zwei Motorwicklungen 11, 12 fließt. Durch den relativ geringen Widerstand der in diesem Kreis liegenden Wicklungen und Halbleiter wird die Stromstärke und ein dadurch an dem Shunt 25 erzeugter Spannungswert in einer kurzen Zeit $t_1$ einen Referenzwert $i_{ref}$ der Auswerteschaltung 237 erreichen. Die dadurch ausgelöste Signaländerung wird vom Mikrocontroller 24 ausgewertet und die Ansteuerung der vorstehend genannten Schalttransistoren 2311 und 2322 abgeschaltet und damit die Zwischenkreisspannung von den Wicklungen 11, 12 des Motors 1 abgeschaltet. Die Zeit $t_1$ ist nun ein Maß für die Größe des Stromflusses. Nach Messung der besagten Zeit $t_1$ wird jeweils die Zwischenkreisspannung U von dem Mikrocontroller 24 über den Spannungsteiler 238 zum Abgreifen der Zwischenkreisspannung und A/D-Wandler 241 ausgewertet. Damit lassen sich nun folgende Rechengrößen ermitteln:

$$i_{ref} = \frac{U}{R}\left(1 - e^{-t1/\tau}\right) \qquad (1)$$

Daraus folgt die Änderung des Wicklungswiderstands entsprechend zu:

$$\Delta R = \frac{U}{i_{ref}} (1 - e^{-t1/\tau}) - R_{20}$$

mit

$t_1 =$      Zeit vom Einschalten bis zum Erreichen eines Meßzeitpunktes;
$\tau =$      Wicklungszeitkonstante UR;
$i_{ref} =$      Referenzwert des Wicklungsstromes;
$U =$      Zwischenkreisspannung und
$R =$      momentaner Wicklungswiderstand

Zur Erfassung der mittleren Temperaturzunahme der Wicklung kann nun immer in Drehpausen, also bei Stillstand des Motors, der Wicklungswiderstand ermittelt werden. Mit:

$R_{20} =$      Kaltwiderstand oder Bezugswiderstand, und
$k_P =$      Proportionalitätsfaktor

läßt sich für die ermittelten Widerstandswerte die Temperaturänderung $\Delta T$ berechnen zu:

$$R = R_{20}(1+^*k_P{}^*\Delta T)$$

Daraus ergibt sich schließlich die Temperaturänderung $\Delta T$ als:

$$\Delta T = \frac{R - R_{20}}{R_{20} {}^* k_P} \tag{2}$$

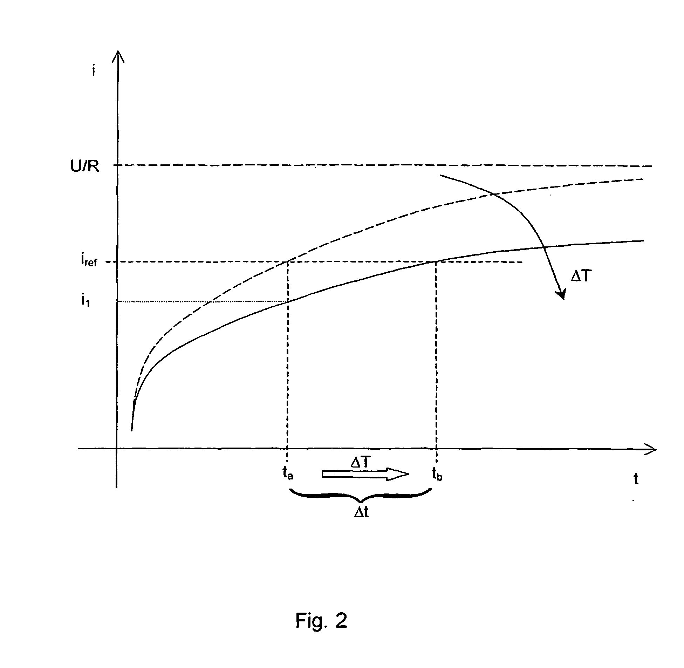

Die Abbildung von Fig. 2 zeigt ein Diagramm zur Darstellung des prinzipiellen zeitlichen Verlaufes des temperaturabhängigen Widerstands einer Motorwicklung. In Abhängigkeit von der Wicklungserwärmung verläuft die Kurve des Stromanstiegs gemäß Gleichung (1) unterschiedlich steil. Dabei verhält sich die Wicklung insgesamt wie ein Kaltleiter, d.h. der Widerstand der Wicklung nimmt bei wachsender Temperatur gut meßbar zu. Damit wird ein Schwellwert $i_{ref}$ bei einer kälteren Wicklung stets später als bei einer weiter erwärmten Wicklung erreicht. Die relativ genaue Bestimmung dieser Zeitdifferenz vom Beginn der Strommessung bis zum Erreichen des Schwellwertes ist damit sehr wichtig.

Eine zweite Ausführungsform baut auf der Kenntnis der Kurvenform und deren Parameter sowie der vorstehend beschriebenen Temperatureinflüsse auf den Kurvenverlauf auf. Von einem definierten Stromwert aus, hier wird weiterhin der Stillstand des Motors 1 mit dem damit verbundenen Stromwert 0 bevorzugt, wird das Ansteigen des Stromflusses bei Anlegen einer Spannung, vorzugsweise der durch den Spannungsteiler 238 und den A/D-Wandler 241 in dem Mikrocontroller 24 bekannten Zwischenkreis-Gleichspannung, beobachtet. Zwei in einem genau bekannten zeitlichen Abstand $\Delta t$ aufeinanderfolgende Strommessungen ermöglichen so über den Kurvenverlauf eine Bestimmung der Wicklungserwärmung über den aktuellen Wicklungswiderstand. Bei diesem Verfahren ist die Zeitmessung unkritischer, da auch nur ein fester Zeitabstand $\Delta t$ vorgegeben werden kann. Die Genauigkeit der indirekten Temperaturbestimmung hängt hier vielmehr von der Güte der vorzunehmenden beiden Strommessungen ab.

In beiden Verfahren ist die Strombelastung der Wicklung durch den Meßstrom im Stillstand in jedem Fall von so kurzer Dauer, dass hierdurch selber keine meßbare Änderung der Wicklungstemperatur bewirkt wird. Femer kann in beiden Verfahren der Wert der Temperaturänderung $\Delta T$ je nach Aufbau und Auslegung einer Auswertungsschaltung innerhalb des Mikrocontrollers 24 nach Gleichung (2) mit einem maximalen Wert $T_{max}$ oder einem absoluten Wert T' verglichen werden.

Meßverfahren der vorstehend beschriebenen Art können insbesondere dann sinnvoll eingesetzt werden, wenn auf eine aufwendige Stromerfassung, wie diese z.B. für eine feldorientierte Regelung bei Asynchronmotoren eingesetzt wird, verzichtet werden kann. Als Einsatzbeispiel ist der Trommelantrieb bei einer Waschmaschine zu nennen, wobei der Motor 1 die Waschtrommel 14 über einen Keilriemen 15 antreibt. Die Temperaturüberwachung ist in der Waschmaschine beim Waschvorgang deswegen besonders wichtig, weil hier bei einem hohen Moment und somit auch eine hohe Strombelastung auftritt. Zudem läuft der Motor 1 in dieser Betriebssituation mit niedriger Drehzahl, so dass auch nur eine geringe Kühlung vorhanden ist. Die Situation beim Schleudern hingegen ist demgegenüber günstiger, weil hier bei wesentlich höherer Drehzahl das Antriebsmoment und damit auch die anfallende Stromwärme niedriger sind.

Da neben unzureichender Kühlung auch ein Überstrom zu überhöhten Temperaturen der Wicklung führen kann, wird in einer dritten Ausführungsform, die zugleich mit einer der beiden vorstehend beschriebenen Meßverfahren kombinierbar ist, der Strom i gemessen oder überwacht. Dies geschieht dadurch, dass im Betrieb des Motors 1 die Stromauswerteschaltung 237 den Rückflußstrom aus dem Wechselrichter 23 auswertet. Diese Überwachung kann als Strommessung in der Stromauswerteschaltung 237 alleine, oder aber über dem Shunt 25 als Spannungsabfall ausgebildet sein. Zur wesentlichen Vereinfachung der Verfahrens wird die Überwachung über zwei Fensterkomparatoren mit zwei unterschiedlichen Schwellwerten vorgenommen. Ein angesprochener Komparator gibt damit keine analogen Signale, sondern nur ein digitales Schaltsignal weiter. Die erste Schwelle liegt etwas oberhalb des Steuerungsgrenzstromes der PWM. Während eines störungsfreien Betriebs des Wechselrichters 23 wird diese Strombelastung in der Regel nicht erreicht. Der Wert der ersten Schwelle liegt bei ca. 60% der zweiten Schwelle, die mithin den Punkt einer Stromüberlastung definiert. Mit Erreichen der zweiten Schwelle wird daher durch den Mikrocontroller 24 oder eine nachgeordnete Steuerungseinheit eine sofortige Notabschaltung des Motors 1 bewirkt.

Bezugszeichenliste

| 1. | Asynchronmotor | | |
|----|----|----|----|
| 2. | Umrichter | | |
| | 21 | Gleichrichter | |
| | 22 | Gleichspannungszwischenkreis | |
| | 23 | 3-phasiger Wechselrichter | |
| | | 231 | Halbbrücke |
| | | 232 | Halbbrücke |
| | | 233 | Halbbrücke |
| | | | 2311 Leistungshalbleiter |
| | | | 2312 Leistungshalbleiter |
| | | | 2321 Leistungshalbleiter |
| | | | 2322 Leistungshalbleiter |
| | | | 2331 Leistungshalbleiter |
| | | | 2332 Leistungshalbleiter |
| | | 234 | Treiber |
| | | 235 | Treiber |
| | | 236 | Treiber |
| | | 237 | Stromauswerteschaltung |
| | | 238 | Spannungsteiler zum Abgreifen der Zwischenkreisspannung |
| | 24 | Mikrocontroller | |
| | | 241 | analog/digital-Wandler (A/D-Wandier-Eingang) |
| | | 242 | Speicherbaustein |
| | 25 | Stromerfassungsschaltung / Shunt | |
| 3. | | | |
| 4. | Wechselspannungsnetz | | |
| | 11 | Wicklung | |
| | 12 | Wicklung | |

(fortgesetzt)

| 13 | Wicklung |
|----|----------|
| 14 | Waschtrommel |
| 15 | Keilriemen |

**Patentansprüche**

1.  Verfahren zum Messen der Wicklungstemperatur (T) eines Antriebsmotors (1), der über einen Wechselrichter (23) mit einem Gleichspannungszwischenkreis (22) verbunden ist, bei welchem
eine Spannung des Gleichspannungszwischenkreis (22) bestimmt wird,
ein Stromfluss (i) mindestens durch eine der Motorwicklungen (11, 12, 13) durch den Wechselrichter (23) hindurch ermittelt wird,
die Zeit ($t_1$) des Anstiegs des Stroms (i) vom Anlegen einer Messspannung an bis zum Erreichen mindestens eines Referenzwertes ($i_{ref}$) oder der Stromanstieg während eines festen Zeitintervalls ($\Delta t$) gemessen wird,
und aus der Änderung des Stromflusses (i) während der gemessenen Zeit ($t_1$) oder des festen Zeitintervalls ($\Delta t$) und aus der Spannung unter mindestens ungefährer Kenntnis eines Kaltwiderstands ($R_{20}$) und sonstiger Parameter des Motors (1) über einen temperaturabhängigen Widerstand (R) oder über eine Änderung des temperaturabhängigen Widerstands ($\Delta R$) eine Temperatur (T) oder eine Temperaturänderung ($\Delta T$) der Motorwicklungen (11, 12, 13) berechnet wird.

2.  Verfahren nach Anspruch 1, **dadurch gekennzeichnet, dass** der Antriebsmotor (1) ein dreisträngiger Motor ist, der über den Wechselrichter (23) mit drei gesteuerten Halbbrücken (231, 232, 233) aus dem Gleichspannungszwischenkreis (22) gespeist wird.

3.  Verfahren nach Anspruch 1 oder 2, **dadurch gekennzeichnet, dass** die Messungen bei Stillstand des Motors (1) vorgenommen werden.

4.  Verfahren nach Anspruch 2 oder 3, **dadurch gekennzeichnet, dass** die Messung gleichzeitig über zwei Wicklungen (11,12,13) des Motors (1) erfolgt.

5.  Verfahren nach einem der vorhergehenden Ansprüche, **dadurch gekennzeichnet, dass** die Messung zur Bestimmung einer relativen Abweichung durchgeführt wird.

6.  Verfahren nach einem der vorhergehenden Ansprüche, **dadurch gekennzeichnet, dass** die Messergebnisse vorangehender Messungen gespeichert werden.

7.  Verfahren nach einem der vorhergehenden Ansprüche, **dadurch gekennzeichnet, dass** eine Rückmeldung an eine Motorsteuerung gegeben wird, so dass insbesondere Betriebsphasen des Motors (1) reduziert werden.

8.  Verfahren nach Anspruch 7, **dadurch gekennzeichnet, dass** durch die Motorsteuerung eine Meldung an einen Anwender ausgelöst wird, insbesondere in Form eines optischen und/oder akustischen Signals.

9.  Vorrichtung (1) zum Messen der Wicklungstemperatur (T) eines Antriebsmotors (1), der über einen Wechselrichter (23) mit einem Gleichspannungszwischenkreis (22) verbunden ist, mit einer Strommesseinrichtung (237) und mit einer Spannungsmesseinrichtung (238, 241), die mit einem Rechenwerk zur Bestimmung eines momentanen temperaturabhängigen Widerstands (R) aus dem gemessenen Strom und der gemessenen Spannung verbunden sind, wobei das Rechenwerk mit einem Speicherbaustein (242) verbindbar ist, in dem der ungefähre Wert des Kaltwiderstands ($R_{20}$) und sonstiger Parameter des Motors (1) abgespeichert sind, und wobei das Rechenwerk zur Bestimmung einer Temperatur (T) oder einer Temperaturänderung ($\Delta T$) der Motorwicklungen (11, 12, 13) unter mindestens ungefährer Kenntnis des Kaltwiderstands ($R_{20}$) und sonstiger Parameter des Motors (1) auf der Basis des momentanen temperaturabhängigen Widerstands (R) oder einer momentanen Änderung des temperaturabhängigen Widerstands ($\Delta R$) ausgebildet ist, zur Durchführung des Verfahrens nach einem der Ansprüche 1 bis 8, **dadurch gekennzeichnet, dass** die Spannungsmesseinrichtung (238, 241) zur Messung einer Spannung des Gleichspannungszwischenkreis (22) ausgebildet ist, dass die Strommesseinrichtung (237) zur Messung des Stromflusses mindestens durch eine der Motorwicklungen (11, 12, 13) durch den Wechselrichter (23) hindurch ausgebildet ist, dass in der Strommesseinrichtung (237) zur Messung der Zeit ($t_1$) des Anstiegs des Stroms (i) vom Anlegen einer Messspannung an bis zum Erreichen mindestens eines Referenzwertes ($i_{ref}$) mindestens ein Schwellwertkomparator und eine Zeitmessvorrichtung vorhanden sind oder dass mit der Strommesseinrichtung (237) zwei Strommessungen in einem definierten zeitlichen Abstand ($\Delta t$) durchführbar sind, und dass das Rechenwerk zur Bestimmung der Temperatur (T) oder einer Temperaturänderung ($\Delta T$) der Motorwicklungen (11, 12, 13) aus der Änderung des Stromflusses (i) während der gemessenen Zeit ($t_1$) oder des festen Zeitintervalls ($\Delta t$) ausgebildet ist.

**10.** Vorrichtung nach Anspruch 9, **dadurch gekennzeichnet, dass** der Antriebsmotor (1) ein dreisträngiger Motor ist, der über den Wechselrichter (23) mit drei gesteuerten Halbbrücken (231, 232, 233) mit dem Gleichspannungszwischenkreis (22) verbunden ist.

**11.** Vorrichtung nach einem der Ansprüche 9 oder 10, **dadurch gekennzeichnet, dass** das Rechenwerk Teil eines Mikrocontrollers (24) ist.

**12.** Vorrichtung nach Anspruch 11, **dadurch gekennzeichnet, dass** der Schwellwertkomparator und die Zeitmessvorrichtung in dem Mikrocontroller (24) vorhanden sind.

**13.** Vorrichtung nach einem der Ansprüche 9 bis 12,**dadurch gekennzeichnet, dass** in der Vorrichtung zwei Schwellwertkomparatoren zur Überwachung von zwei Stromschwellen vorgesehen sind, wobei die eine Stromschwelle insbesondere etwas oberhalb eines Steuerungsgrenzstromes einer PWM zur Steuerung von Leistungsschaltern (2311, 2312, 2321, 2322, 2331, 2332) eines Umrichters oder Wechselrichters (23) liegt und der Wert der ersten Schwelle bei ca. 60% der zweiten Schwelle liegt, bei dessen Erreichen der Mikrocontroller (24) oder eine nachgeordnete Steuerungseinheit zur sofortigen Auslösung einer Notabschaltung des Motors 1 ausgebildet ist.

**14.** Hausgerät mit einem Steuerungssystem, das nach einem Verfahren gemäß einem der Ansprüche 1 bis 8 oder mit einer Vorrichtung nach einem der Ansprüche 9 bis 13 ausgebildet ist.

## Claims

**1.** Method of measuring the winding temperature (T) of a drive motor (1) connected with a direct voltage intermediate circuit (22) by way of an inverter (23), in which a voltage of the direct voltage intermediate circuit (22) is determined, a current flow (i) at least through one of the motor windings (11, 12, 13) is ascertained through the inverter (23), the time ($t_1$) of the rise in the current (i) from application of a measurement voltage up to attainment of at least one reference value ($i_{ref}$) or of the current rise during a fixed time period (At) is measured and a temperature (T) or a temperature change ($\Delta T$) of the motor windings (11, 12, 13) is calculated from the change in the current flow (i) during the measured time ($t_1$) or the fixed time period ($\Delta t$) and from the voltage with at least approximate knowledge of a cold resistance ($R_{20}$) and other parameters of the motor (1) by way of a temperature-dependent resistance (R) or by way of a change in the temperature-dependent resistance ($\Delta R$).

**2.** Method according to claim 1, **characterised in that** the drive motor (1) is a triple-strand motor supplied with current by way of the inverter (22) with three controlled half bridges (231, 232, 233) from the direct voltage intermediate circuit (22).

**3.** Method according to claim 1 or 2, **characterised in that** the measurements are undertaken at standstill of the motor (1).

**4.** Method according to claim 2 or 3, **characterised in that** the measuring is carried out simultaneously over two windings (11, 12, 13) of the motor (1).

**5.** Method according to one of the preceding claims, **characterised in that** the measurement is carried out for determination of a relative deviation.

**6.** Method according to one of the preceding claims, **characterised in that** the measurement results of preceding measurements are stored.

**7.** Method according to one of the preceding claims, **characterised in that** a feedback to a motor control is given so that, in particular, operating phases of the motor (1) are reduced.

8. Method according to claim 7, **characterised in that** a report to a user is triggered, particularly in the form of an optical and/or acoustic signal, by the motor control.

9. Device (1) for measuring the winding temperature (T) of a drive motor (1), which is connected with a direct voltage intermediate circuit (22) by way of an inverter (23), with a current measuring device (237) and with a voltage measuring device (238, 241), which are connected with an arithmetic and logic unit for determination of an instantaneous temperature-dependent resistance (R) from the measured current and the measured voltage, wherein the arithmetic and logic unit is connectible with a memory block (242), in which the approximate value of the cold resistance ($R_{20}$) and other parameters of the motor (1) are stored, and wherein the arithmetic and logic unit is constructed for determination of a temperature (T) or a temperature change ($\Delta$T) of the motor windings (11, 12, 13) with at least approximate knowledge of the cold resistance ($R_{20}$) and other parameters of the motor (1) on the basis of the instantaneous temperature-dependent resistance (R) or an instantaneous change in the temperature-dependent resistance ($\Delta$R), for carrying out the method according to one of claims 1 to 8, **characterised in that** the voltage measuring device (238, 241) is constructed for measuring a voltage of the direct voltage intermediate circuit (22), that the current measuring device (237) is constructed for measuring the current flow at least through one of the motor windings (11, 12, 13) through the inverter (23), that at least one threshold value comparator and a time measuring device for measuring the time ($t_1$) of the rise in the current (i) from application of a measuring voltage up to attainment of at least one reference value ($i_{ref}$) are present in the current measuring device (237) or that two current measurements can be undertaken at a defined spacing in time ($\Delta$t) by the current measuring device (237) and that the arithmetic and logic unit is constructed for determining the temperature (T) or a temperature change ($\Delta$T) of the motor windings (11, 12, 13) from the change in the current flow (i) during the measured time ($t_1$) or the fixed time period ($\Delta$t).

10. Device according to claim 9, **characterised in that** the drive motor (1) is a triple-strand motor which is connected with the direct voltage intermediate circuit (22) by way of the inverter (23) with three controlled half bridges (231, 232, 233).

11. Device according to one of claims 9 and 10, **characterised in that** the arithmetic and logic unit is part of a microcontroller (24).

12. Device according to claim 11, **characterised in that** the threshold value comparator and the time measuring device are present in the microcontroller (24).

13. Device according to one of claims 9 to 12, **characterised in that** two threshold value comparators for monitoring two current thresholds are present in the device, wherein one current threshold in particular lies somewhat above a control limit current of a PWM for control of power switches (2311, 2312, 2321, 2322, 2331, 2332) of a converter or inverter (23) and the value of the first threshold lies at approximately 60% of the second threshold, on attainment of which the microcontroller (24) or a downstream control unit is constructed for immediate triggering of an emergency switching-off of the motor (1).

14. Domestic appliance with a control system which is constructed according to a method according to one of claims 1 to 8 or with a device according to one of claims 9 to 13.

**Revendications**

1. Procédé pour mesurer la température d'enroulements (T) d'un moteur d'entraînement (1) qui est raccordé à un circuit intermédiaire à tension continue (22) par l'intermédiaire d'un convertisseur continu-alternatif (23), dans lequel
une tension du circuit intermédiaire à tension continue (22) est déterminée,
un flux de courant (i) est déterminé au moins par l'un des enroulements de moteur (11, 12, 13) à travers le convertisseur continu-alternatif (23),
le temps ($t_1$) d'accroissement du courant (i), de l'application d'une tension de mesure jusqu'à l'obtention d'au moins une valeur de référence ($i_{ref}$), ou l'accroissement du courant pendant un intervalle de temps ($\Delta$t) fixe est mesuré, et une température (T) ou une variation de température ($\Delta$T) des enroulements de moteur (11, 12, 13) est calculée à partir de la modification du flux de courant (i) pendant le temps ($t_1$) mesuré ou l'intervalle de temps ($\Delta$t) fixe et à

partir de la tension, en ayant au moins la connaissance approximative d'une résistance à froid ($R_{20}$) et d'autres paramètres du moteur (1), par l'intermédiaire d'une résistance (R) dépendant de la température ou par l'intermédiaire d'une modification de la résistance ($\Delta$R) dépendant de la température.

2. Procédé selon la revendication 1, **caractérisé en ce que** le moteur d'entraînement (1) est un moteur à trois phases qui, par l'intermédiaire du convertisseur continu-alternatif (23), est alimenté au moyen de trois demi-ponts (231, 232, 233) commandés du circuit intermédiaire à tension continue (22).

3. Procédé selon la revendication 1 ou 2, **caractérisé en ce que** les mesures sont réalisées à l'arrêt du moteur (1).

4. Procédé selon la revendication 2 ou 3, **caractérisé en ce que** la mesure est réalisée simultanément par l'intermédiaire de deux enroulements (11, 12, 13) du moteur (1).

5. Procédé selon l'une quelconque des revendications précédentes, **caractérisé en ce que** la mesure est réalisée pour déterminer un écart relatif.

6. Procédé selon l'une quelconque des revendications précédentes, **caractérisé en ce que** les résultats de mesures précédentes sont mémorisés.

7. Procédé selon l'une quelconque des revendications précédentes, **caractérisé en ce qu'**une information de retour est donnée à une commande de moteur, de sorte que notamment des phases de fonctionnement du moteur (1) sont réduites.

8. Procédé selon la revendication 7, **caractérisé en ce qu'**un message à un utilisateur est déclenché par la commande du moteur, notamment sous forme d'un signal optique et/ou acoustique.

9. Dispositif (1) pour mesurer la température d'enroulements (T) d'un moteur d'entraînement (1) qui est raccordé à un circuit intermédiaire à tension continue (22) par l'intermédiaire d'un convertisseur continu-alternatif (23), comprenant un dispositif de mesure du courant (237) et un dispositif de mesure de la tension (238, 241) qui sont raccordés à une unité de calcul pour déterminer une résistance (R) momentanée dépendant de la température à partir du courant mesuré et de la tension mesurée, l'unité de calcul pouvant être connectée à un module de mémoire (242), dans lequel la valeur approximative de la résistance à froid ($R_{20}$) et d'autres paramètres du moteur (1) sont mémorisés, et l'unité de calcul étant exécutée pour déterminer une température (T) ou une variation de température ($\Delta$T) des enroulements de moteur (11, 12, 13) en ayant au moins la connaissance approximative de la résistance à froid ($R_{20}$) et d'autres paramètres du moteur (1), sur la base de la résistance (R) momentanée dépendant de la température ou d'une modification momentanée de la résistance ($\Delta$R) dépendant de la température, destiné à la réalisation du procédé selon l'une quelconque des revendications 1 à 8, **caractérisé en ce que** le dispositif de mesure de la tension (238, 241) est exécuté pour mesurer une tension du circuit intermédiaire à tension continue (22), **en ce que** le dispositif de mesure du courant (237) est exécuté pour mesurer le flux de courant à travers l'un des enroulements (11, 12, 13) au moyen du convertisseur continu-alternatif (23), **en ce qu'**au moins un comparateur de seuils et un dispositif de mesure de temps sont présents dans le dispositif de mesure du courant (237) pour mesurer le temps ($t_1$) de l'accroissement du courant (i), de l'application d'une tension de mesure jusqu'à l'obtention d'au moins une valeur de référence ($i_{ref}$), ou **en ce qu'**au moyen du dispositif de mesure du courant (237), deux mesures de courant sont réalisables dans un écart temporel ($\Delta$t) défini, et **en ce que** l'unité de calcul est exécutée pour déterminer la température (T) ou une variation de température ($\Delta$T) des enroulements de moteur (11, 12, 13) à partir de la modification du flux de courant (i) pendant le temps mesuré (t1) ou l'intervalle de temps fixe ($\Delta$t).

10. Dispositif selon la revendication 9, **caractérisé en ce que** le moteur d'entraînement (1) est un moteur à trois phases, qui, par l'intermédiaire du convertisseur continu-alternatif (23), est raccordé au circuit intermédiaire à tension continue (22) au moyen de trois demi-ponts (231, 232, 233) commandés.

11. Dispositif selon l'une quelconque des revendications 9 ou 10, **caractérisé en ce que** l'unité de calcul fait partie d'un microcontrôleur (24).

12. Dispositif selon la revendication 11, **caractérisé en ce que** le comparateur de seuils et le dispositif de mesure du temps sont présents dans le microcontrôleur (24).

**13.** Dispositif selon l'une quelconque des revendications 9 à 12, **caractérisé en ce que** deux comparateurs de seuils sont prévus dans le dispositif pour surveiller deux seuils de courant, l'un des seuils étant situé notamment un peu au-dessus d'un courant limite de commande d'une modulation de largeur d'impulsions pour la commande de commutateurs de puissance (2311, 2312, 2321, 2322, 2331, 2332) d'un convertisseur ou convertisseur continu-alternatif (23) et **en ce que** la valeur du premier seuil est située à env. 60% du deuxième seuil, à l'obtention de laquelle le microcontrôleur (24) ou une unité de commande installée en aval est exécutée pour le déclenchement immédiat d'un arrêt d'urgence du moteur 1.

**14.** Appareil domestique comprenant un système de commande qui est exécuté selon un procédé conforme à l'une quelconque des revendications 1 à 8 ou comprenant un dispositif selon l'une quelconque des revendications 9 à 13.

Fig. 1

230V AC

Fig. 2